# EUROPÄISCHE PATENTSCHRIFT

(11) **EP 1 958 254 B1**
(45) Veröffentlichungstag und Bekanntmachung des Hinweises auf die Patenterteilung: **15.05.2019**
(21) Anmeldenummer: 06829445.3
(22) Anmeldetag: 08.12.2006
(51) Int. Cl.: H01L 23/473

(54) **MIKROWÄRMEÜBERTRÄGER SOWIE DIE VERWENDUNG DESSELBEN ALS FLUIDKÜHLER FÜR ELEKTRONISCHE BAUTEILE**
MICRO-HEAT EXCHANGER AND THE USE THEREOF AS A FLUID COOLER FOR ELECTRONIC COMPONENTS
MICRO-ECHANGEUR THERMIQUE ET SON UTILISATION EN TANT QUE DISPOSITIF DE REFROIDISSEMENT PAR LIQUIDE POUR COMPOSANTS ELECTRONIQUES

(30) Priorität: 09.12.2005 DE 102005058780
(43) Veröffentlichungstag der Anmeldung: 20.08.2008
(73) Patentinhaber: Karlsruher Institut für Technologie, 76131 Karlsruhe (DE)
(72) Erfinder: SCHUBERT, Klaus, 76227 Karlsruhe (DE); BRANDNER, Jürgen, 69207 Sandhausen (DE); SCHYGULLA, Ulrich, 76646 Bruchsal (DE); ANURJEW, Eugen, 76139 Karlsruhe (DE); HANSJOSTEN, Edgar, 76149 Karlsruhe (DE)
(86) Internationale Anmeldenummer: PCT/EP2006/011849
(87) Internationale Veröffentlichungsnummer: WO 2007/065705

(56) Entgegenhaltungen:
- DE-A1- 19 536 115
- DE-A1- 19 734 054
- US-A1- 2002 075 651
- US-A1- 2004 154 788
- US-A1- 2004 182 560
- US-B1- 6 337 794

## Beschreibung

Die Erfindung betrifft einen Mikrowärmeüberträger zur Übertragung von hohen flächenspezifischen Wärmemengen gemäß des ersten sowie die Verwendung desselben als Fluidkühler für ein elektronisches Bauteil gemäß des neunten Patentanspruchs.

Bei technischen Prozessen treten oftmals verlustleistungsabhängige Wärmemengen auf, die durch geeignete Kühlmittel zuverlässig abzuführen sind. Die Ableitung der Wärmemenge erfolgt üblicherweise über Wärme leitende Festkörper und / oder fluidischen Kühlmittelflüssen wie z.B. einer Luft- Öl- oder Wasserkühlung.

Größere spezifische Verlustwärmemengen fallen beispielsweise in der Mikroelektronik, Mikroverfahrenstechnik oder anderen mikrotechnischen Systemen an. Dabei sorgt auch eine immer weiter fortschreitende Miniaturisierung bei gleichzeitiger Leistungserhöhung von elektronischen Komponenten wie Prozessoren eine erhebliche Zunahme der spezifischen Leistungsfähigkeit und damit auch der mit dieser verbundenen spezifischen Verlustleistung. In Folge dessen müssen mit diesem spezifischen Verlustleistungsanstieg auch die Mittel für eine zuverlässige Wärmeabfuhr oder Kühlung verbessert oder weiterentwickelt werden.

Bekannte Kühlmittel für die Mikroelektronik umfassen meist Kühlkörper, die mit dem zu kühlenden elektronischen Bauteil direkt verbunden sind und über eine Kühlrippung die aufgenommene Wärmemenge an ein anströmendes Fluid, vorzugsweise Luft weitergibt. Die Kühlkörper erfassen die abzuleitende Wärmemenge aufgrund ihrer guten Wärmeleitfähigkeit und einer relativ großen Wärmekapazität integral und gleichen somit lokal auftretende Temperaturschwankungen in einem gewissen Maße aus.

Bekannte Kühlmittel für die Mikroverfahrenstechnik umfassen z.B. fluidische Mikrowärmetauscher wie Mikrokreuzstrom- oder Gegenstromwärmetauscher mit einer Vielzahl von parallel geschalteten Fluidkanälen. Diese weisen oftmals eine Mikrostrukturierung der Fluidkanäle auf, was aufgrund der dadurch entstandenen großen spezifischen Wärmeübertragungsfläche einerseits und der kurzen zu überbrückenden Wärmeübertragungswege eine hohe spezifische Wärmeübertragungsrate erwarten lässt. Jedoch weisen derartige Systeme prinzipbedingt größere Temperaturunterschiede über die Fluidkanallängen und damit eine ungleichmäßig inhomogene Wärmeabfuhr auf, welche durch verunreinigungsbedingte Verstopfung einzelner Fluidkanälen noch verstärkt wird. Oftmals zeichnen sich derartige mikrostrukturierte Wärmetauscher durch einen hohen Durchströmungswiderstand und damit einem hohen Druckabfall im Kühlmedium beim Durchtritt durch die Mikrokanäle aus, und zwar in besonders starker Abhängigkeit zum Verstopfungsgrad der einzelnen Kanäle.

Übersteigt eine abzugebende spezifische Wärmemenge verbunden mit einer zunehmenden Miniaturisierung und Leistungsfähigkeit zudem eine bestimmte Größe, stoßen bekannte Konzepte schnell an ihre physikalischen Grenzen.

In US 2004/0182560 A1 wird ein Mikrowärmeüberträger zur Übertragung von hohen flächenspezifischen Wärmemengen vorgeschlagen. Er weist einen Wärmeübertragungsbereich, eine Zuleitungs- und eine Ableitungskanalstruktur mit jeweils zugehörigen Verteilungsvolumina und Zu- und Ablauf jeweils für mindestens ein Wärmeüberträgermedium im Mikrowärmeüberträger auf. Über eine Anzahl von Passagen als einzige Verbindung für je ein Wärmeüberträgermedium sind Zu- und Ableitungskanalstruktur miteinander verbunden, wobei die Zu- und Ableitungskanalstrukturen je Wärmeübertragungsmedium in abwechselnder Reihenfolge ineinander verschlungen angeordnet sind.

DE 195 36 115 A1 beschreibt einen Mikrowäremüberträger mit einer Anordnung der Zuleitungs- und Ableitungskanäle in mehreren Ebenen, wobei die Ebenen durch Platten einseitig eingearbeiteten Kanalgruppen und Durchbrüchen als Verbindungsöffnungen in den Kanälen gebildet werden.

Auch offenbart US 2004/0154788 A1 einen Wärmetauscher, umfassend einen Wärmeübertragungsbereich, einer Zu- und einer Ableitungskanalstruktur mit jeweils zugehörigen Verteilungsvolumina und Zu- und Ablauf jeweils für mindestens ein Wärmeüberträgermedium im Mikrowärmeüberträger sowie eine Anzahl von Passagen als einzige Verbindung für je ein Wärmeüberträgermedium jeweils zwischen Zu- und Ableitungskanalstruktur, wobei die Zu- und Ableitungskanalstrukturen je Wärmeübertragungsmedium in abwechselnder Reihenfolge ineinander verschlungen angeordnet sind, die Passagen nahe dem Wärmeübertragungsbereich angeordnet sind und Zuleitungskanalstruktur, Ableitungskanalstrukturen sowie die Passagen sich über den gesamten Wärmeübertragungsbereich erstrecken. Fener sind die Zu- und Ableitungskanalstruktur durch Barrieren in Teilabschnitte unterteilt, wobei jeder Teilabschnitt mit mindestens zwei benachbarten Teilabschnitten über jeweils mindestens einer Passage verbunden ist.

Ausgehend davon liegt die **Aufgabe der Erfindung** darin, einen fluidischen Mikrowärmeüberträger zur Übertragung von hohen flächenspezifischen Wärmemengen vorzuschlagen, der die Einschränkungen und Nachteile der vorgenannten Systeme nicht aufweist und sich in besonderer Weise durch einen geringen Durchströmungswiderstand für ein fluidisches Temperiermedium auszeichnet. Vorzugsweise weist die Erfindung zudem eine über einen vorgegebenen Wärmeübertragungsbereich gleich bleibende spezifische Wärmemengenableitung bei einem über die Fläche gleich bleibenden Temperaturniveau andererseits auf.

Ferner liegt eine Aufgabe der Erfindung darin, einen Fluidkühler für ein elektronisches Bauteil vorzuschlagen.

Die Aufgabe wird mit einem Mikrowärmeüberträger gemäß des ersten sowie einer Verwendung gemäß des neunten Patentanspruchs gelöst. Die auf diesen rückbezogenen Unteranspruche geben vorteilhafte Ausgestaltungen des Mikrowärmeüberträgers wieder.

Ein beispielhafter Mikrowärmeüberträger umfasst den vorgenannten Wärmeübertragungsbereich, je einer Zuleitungskanalstruktur und je einer Ableitungskanalstruktur jeweils für mindestens ein Wärmeüberträgermedium im Mikrowärmeüberträger sowie eine Anzahl von Passagen als einzige Verbindung für je ein Wärmeüberträgermedium jeweils zwischen Zu- und Ableitungskanalstruktur.

Der Wärmeübertragungsbereich umfasst im Rahmen der Erfindung alternativ zu einer Wärmübertragungskomponente zwischen der Wärmeenergiequelle und dem vorgenannten Wärmeübertragungsmedium vorzugsweise eine Wärmeübertragungsfläche, weiter bevorzugt eine Wärmeübertragungsaußenfläche des Mikrowärmeüberträgers zum Anbinden einer zu temperierenden Komponente mit der vorgenannten Wärmeenergiequelle. Die Anbindung kann durch eine kraftschlüssige, formschlüssige oder stoffschlüssige Verbindung geschehen, wobei der Wärmeübergang bei kraftschlüssigen und formschlüssigen Verbindungen durch ein Wärmeankopplungsmedium wie ein Wärmeleitfluid oder eine Wärmeleitpaste verbesserbar ist. Eine stoffschlüssige Verbindung wird beispielsweise durch eine Verlötung oder Verklebung im Rahmen eines Materialverbunds ausgeführt und ähnelt damit, sofern die Wärmeleitfähigkeiten und Wärmekapazitäten der eingesetzten Materialien aufeinander abgestimmt sind, der vorgenannten Ausführung mit einer einstückigen Wärmeübertragungskomponente.

Ein wesentliches Merkmal der Erfindung betrifft Anordnung der Kanalstrukturen je Wärmeübertragungsmedium sowie der Passagen zueinander. Die vorgenannten Kanalstrukturen sind in abwechselnder Reihenfolge ineinander verschlungen und weisen trennende Wandungen auf, die von den Passagen überbrückt werden. Die trennenden Wandungen erstrecken sich wie die Kanalstrukturen bevorzugt über den gesamten Wärmeübertragungsbereich, wobei die Passagen in großer Anzahl parallel geschaltet möglichst weit in den Wärmeübertragungsbereich hineingeleitet werden. Vorzugweise weisen die trennenden Wandungen eine möglichst große Länge auf, wobei die Passagen sich über die gesamte Länge verteilen. Vorzugweise weist die trennende Wandung auch über die gesamte Länge, in der sie von Passagen überbrückt wird, eine gleich bleibende Stärke auf. Ebenso vorteilhaft wie vorzugsweise weisen alle Passagen gleiche Abmessungen hinsichtlich Querschnitt, Länge und relativer Anordnung zum Wärmeübertragungsbereich auf.

Ein erster Vorteil dieser Gestaltung liegt darin, dass durch eine hohe Verzweigung des Wärmüberträgermediumflusses in den Kanalstrukturen und eine weitere, d.h. noch höhere Verzweigung des Wärmüberträgermediumflusses in den Passagen die für eine Wärmeübertragung zur Verfügung stehende spezifische Fläche signifikant erhöht wird, wobei das Maximum der möglichen Wärmeübertragung in den Passagen möglich ist. Da die Passagen sich zudem in den Wärmeübertragungsbereich exponieren, und zwar in gleicher Weise über den gesamten Wärmeübertragungsbereich, erfolgt konsequenter Weise ein Wärmeübergang überwiegend in den Passagen in vorteilhafter Weise praktisch gleichmäßig über den gesamten Wärmeübertragungsbereich. Zusätzliche Massen für einen Temperaturausgleich im Wärmeübertragungsbereich, die nicht nur die Wärmeübertragungswege zum oder von dem Wärmeüberträgermedium und die Verlustleistungen nachteilig vergrößern würden sondern auch die baulichen Abmessungen des Mirkowärmeüberträgers erhöhen, sind somit nicht oder nur in einem wesentlich geringerem Maße erforderlich.

Ein zweiter Vorteil dieser weiten Auffächerung des Wärmüberträgermediumflusses in eine Vielzahl von vorzugsweise in Vergleich zu den Querschittsabmessungen kurzen Passagen liegt im geringen Durchflusswiderstand eines Fluids im Mikrowärmeüberträger. Vorzugsweise weisen die Passagen und die Kanalstrukturen in Summa einen größeren Querschnitt als die Zu- und Ableitungen des Mikrowärmetauschers auf, wobei die Passagenquerschnitte in Summa weiter bevorzugt die aufsummierten Kanalquerschnitte von Zuleitung oder Ableitung übersteigen. Weiter bevorzugt übersteigt die Länge einer jeden Passage keinesfalls dessen fünffache, weiter bevorzugt dessen zweifache maximale Querschnittsabmessung. Wesentlich ist jedoch, dass die Passagen in ihren Abmessungen so gestaltet sind, dass sich eine hydrodynamisch und thermisch nicht ausgebildete Anlaufströmung einstellt. Diese dreidimensionale örtlich nicht ausgebildete Anlaufströmung besitzt in diesem Bereich einen Strömungsvektor mit einer zusätzlichen Komponente senkrecht zur wärmeübertragenden Wandung, was den Wärmeübergang zwischen Wandung und Fluid lokal erhöht. Der Durchströmwiderstand bleibt in diesem Bereich durch die Abmessung der Passagen gering. Findet dabei in den Kanälen überwiegend eine laminare Strömung statt, wird der Wärmeübergang in vorteilhafter Weise noch stärker auf die Bereiche der Passagen konzentriert.

Die Abmessungen des Mikrowärmeüberträgers richten sich im Wesentlichen nach dem Einsatzzweck, wobei sie sich vorzugsweise an die geometrischen Abmessungen der zu kühlenden Komponenten wie z.B. einen adaptierten Mikroreaktor oder ein elektronisches Bauteil anpassen, wobei die Feinheit der Kanalstrukturen, Fluidführungen, Passagen und Wandungen sich durch den Einsatzzweck und die zu übertragenden sepzifische Wärmemenge bestimmt. Die Spanne von Größe und Feinheit werden in praxi primär durch die Herstellungsverfahren begrenzt, wobei der Durchfluss durch das Wärmeübertragungsfluid stets gewährleistet werden muss. Beispielsweise dürfen minimale Verunreinigungen oder Inhomogenitäten im Fluid nicht zu Verstopfungen in den Fluidführungen führen (mögliche Begrenzung der Feinheit nach unten). Je nach geometrischer Größe, Feinheit, Material und wirtschaftlichen Rahmenbedingungen kommen bei der Herstellung der Strukturen im Mikrowärmeüberträger mechanische spangebende oder prägende, erosive (z.B. elektrisch, thermisch oder mechanisch) oder chemisch ätzende Herstellungsverfahren, aber auch Spritzgussverfahren, Abscheidungsverfahren (z.B. Galvanisch), bekannte Mikrostrukturierungsverfahren oder eine Kombination aus den vorgenannten Verfahren in Frage.

Es liegt auch die Verwendung einer oder mehrerer der vorgenannten Mikrowärmeüberträger zur Temperierung von chemische Reaktionen z.B. in einem Mikroreaktor oder von physikalischen oder elektronischen Vorgängen z.B. in einer elektronischen Schaltung, einer Lichtquelle (z.B. Glühlampe, Entladungsvorgänge etc.) oder in einer Abschirmung bei einer Wärme- oder Kältequelle (Schutzschild ohne Temperierung der Quelle selbst) im Rahmen der Erfindung. Der Mikrowärmeüberträger wird dabei je nach Anwendung von außen an einer oder an mehreren oder an allen Seiten einer entsprechenden Vorrichtung zur Durchführung der vorgenannten Vorgänge angesetzt oder ist in dieser Vorrichtung integriert, wobei der jeweilige Wärmeübertragungsbereich mit den Passagen im Mikrowärmeüberträger nicht nur einseitig, sondern auch beidseitig an eine Kanalstruktur angebunden werden kann.

Die Erfindung wird wie folgt mit Ausführungsbeispielen anhand von Figuren näher erläutert. Es zeigen
**Fig.1a** **und b** eine prinzipielle Anordnung der Zu- und Ableitungskanalstrukturen sowie der Passagen eines Beispiels zur Veranschaulichung in perspektivischer Darstellung und in einer Aufsicht,
**Fig.2a** **und b** eine prinzipielle Anordnung der Kanalstrukturen sowie der Passagen der ersten Ausführungsform in perspektivischer Darstellung und in einer Aufsicht,
**Fig.3a** und c Ansichten der Komponenten eines Mikrowärmeüberträgers gemäß eines Beispiels zur Veranschaulichung,
**Fig.4a** **und b** zwei Schnittdarstellungen des in **Fig. 3** dargestellten Mikrowärmeüberträgers orthogonal zu den Kanalstrukturen,
**Fig.5** eine Schnittdarstellung entsprechend **Fig.4a** **und b** einer alternativen konstruktiven Gestaltung,
**Fig.6** eine Schnittdarstellung entsprechend **Fig.4a** **und b** einer alternativen konstruktiven Gestaltung für den Einsatz als Fluidkühler für elektronische Bauteile auf einer Leiterplatte,
**Fig.7a** **bis d** Aufsichten der strukturierten Folien eines Mikrowärmeüberträgers gemäß einer weiteren Ausführungsform sowie
**Fig.8** eine Schnittdarstellungen der in **Fig.7 a bis d** dargestellten Ausführungsform.

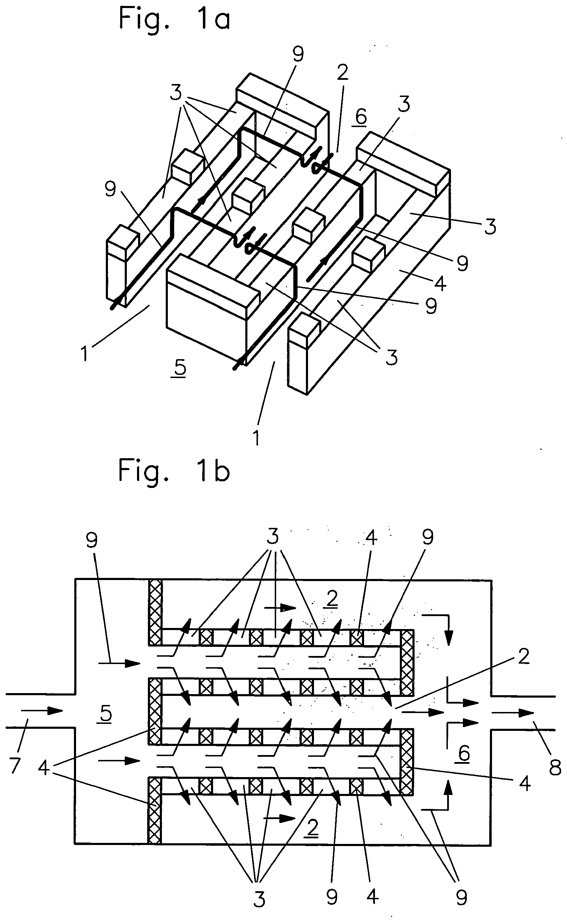

Beispielhafte Anordnungen der Kanalstrukturen (1 und 2) sowie der Passagen **3** über die trennenden Wandungen **4** sind in **Fig.1a** **und b** prinzipiell dargestellt. Die beiden Kanalstrukturen **1** und **2** sind im Beispiel in abwechselnder Reihenfolge durch sich abwechselnde parallele Kanäle gebildet, die in einer Ebene angeordnet von jeweils einem Verteilungsvolumen **5** und **6** für den Zulauf **7** bzw. Ablauf **8** ausgehen. Die trennenden Wandungen sind in der dargestellten Anordnung über die gesamte Wandungslänge ungefähr gleich dick wobei die überbrückenden Passagen zur Erzielung gleicher oder ähnlicher Strömungsverhältnisse in allen Passagen möglichst identische Abmessungen aufweisen und nur in die Kanalstrukturen und nicht in die Verteilungsvolumina ausmünden. Die Durchströmungsrichtungen **9** des Wärmeübertragungsmediums durch die Anordnung sind durch eine Anzahl Pfeile wiedergegeben.

Andere Anordnungen, wie z.B. meander- oder spiralförmig ineinander verschlungene Kanalstrukturen sind grundsätzlich denkbar, müssen jedoch ebenfalls den vorgenannten Auslegungskriterien hinsichtlich einer vorzugsweise einzustellenden laminaren Fluidströmung in den Kanalstrukturen **1** und **2** und einer vorteilhaften turbulenten Strömung in den Passagen **4** genügen.

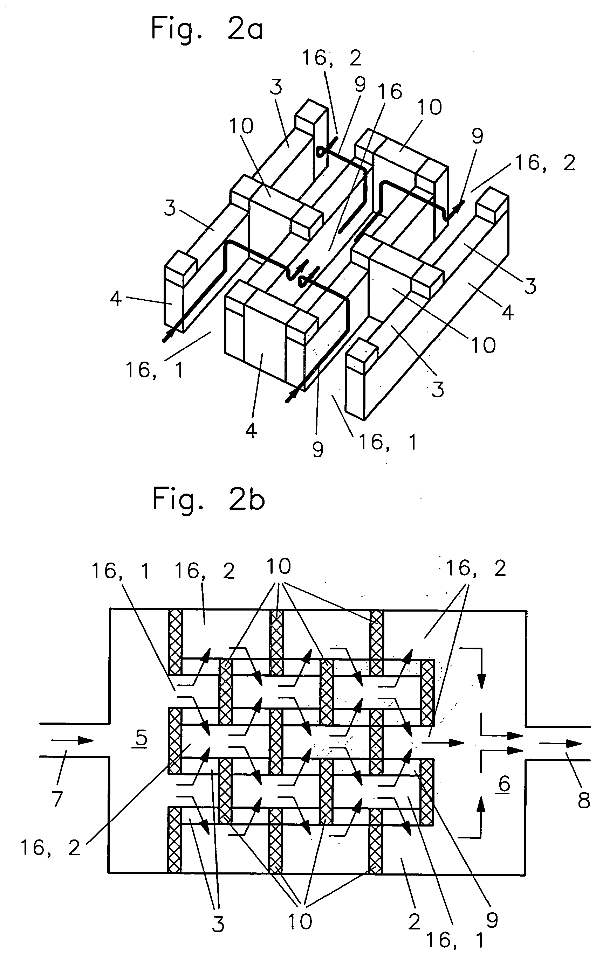

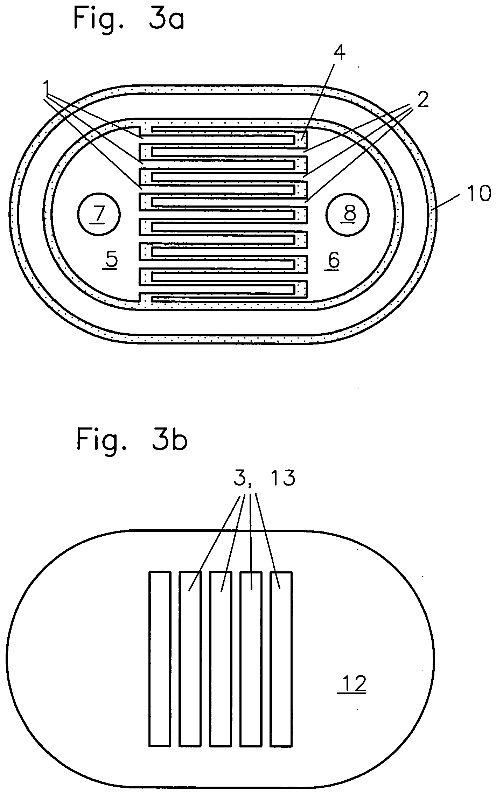

**Fig.2a** **und b** repräsentiert eine erste Ausführungsform in denselben Ansichten und Bezugszeichen wie **Fig.1a** **und b.** Im Gegensatz zur beispielhaften Darstellung (Fig. 1a und 1b) durchströmt ein Wärmeübertragungsmedium nicht nur eine, sondern hintereinander mehrere Passagen **4,** wozu die vorgenannten Kanalstrukturen **1** und **2** durch fluiddichte Barrieren **10** in Teilabschnitte **16** unterteilt sind. Das Wärmeübertragungsmedium wechselt bei der Durchströmung der Anordnung mehrfach zwischen den vorgenannten Teilabschnitten der Kanalstrukturen 1 und 2 hin und her, wobei bei jeder Passage eine Wärmemenge abgeben oder aufgenommen wird. Dabei ist es unerheblich und in jedem Fall im Rahmen dieser Erfindung, ob die Barrieren 10 wie in Fig.2a fluchtend zueinander in derselben Kanalstruktur (1 oder 2) angeordnet sind, während der benachbarte Kanal mit den Teilabschnitten beidseitig verschlossen ist und nur über die Passagen **3** mit den vorgenannten Kanalstrukturen **1** und **2** verbunden ist oder wie in **Fig.2b** dargestellt, die Anordnung den Kanalstrukturen **1** bzw. **2** wie in **Fig.1a** **und b** oder auch in **Fig.3a** **und b** entsprechend alternierend angeordnet sind. Bei der in **Fig.2a** gezeigten Variante nimmt ein Teil der Barrieren **10** die Funktion der trennenden Wandungen **4** ein. In jedem Fall ändert sich auch mit jeder Passagendurchströmung die Temperatur im Wärmeübertragungsmedium. Im Gegensatz zum Beispiel zur Veranschaulichung, bei dem alle Passagen eine möglichst gleiche Temperatur aufweisen sollen, liegt das Ziel der ersten Ausführungsform in einem möglichst hohen thermischen Wirkungsgrad bei gleichzeitig hoher flächenspezifischer Leistung und geringem Durchströmungswiderstand.

In **Fig. 1a** **und b sowie 2a und b** sind die Wärmeübertragungsbereiche, die sich einseitig oder beidseitig zu den dargestellten Anordnungen anschließen, nicht weiter dargestellt.

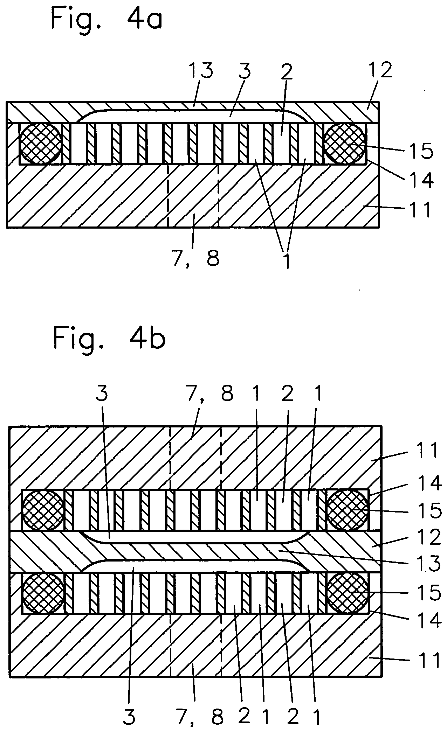

Insbesondere in **Fig. 1a** **und b sowie 2a und b** sind die vorzugsweise angestrebten Proportionen der Passagen **3** wiedergegeben. Die Passagenlänge entspricht der Überbrückungsstrecke (Dicke) der Wandungen **4.** Der Passagenquerschnitt ist so bemessen, dass einerseits ein möglichst geringer Strömungswiderstand auftritt, andererseits ein möglichst hoher Wärmeübergang direkt und nicht über zusätzliche Elemente wie seitliche Querschnittsbegrenzungen oder Kühlrippen indirekt an die angrenzenden Wärmeübertragungsbereiche **13** (vgl. z.B. **Fig.4a**) ermöglicht wird. Folglich ist der Querschnitt der Passagen absolut möglichst groß gewählt. Außerdem ist das Verhältnis von Breite/Höhe des Querschnitts zugunsten einer möglichst großen Wärmeübertragungsfläche direkt zu den sich eben erstreckenden Wärmeübertragungsbereichen möglichst groß, d.h. über 1, vorzugsweise über 3, weiter bevorzugt über 5. Die Passagen werden, wie in **Fig.1a** **und** **2a** dargestellt, durch Stege (auf den Wandungen **4** zwischen den Passagen **3** aufgesetzt) begrenzt. Diese wirken wie Abstandshalter zu den in **Fig.1a** **und** **2a** nicht dargestellten Wärmeübertragungsbereichen und entsprechen in ihrer Höhe denen der Passagenquerschnitte. Sie dienen als seitliche Begrenzungen der Passagen und stellen grundsätzlich eine Strömungsbarriere dar. Folglich sind diese Stege in ihren lateralen Ausdehnungen möglichst schmal gehalten und weisen bevorzugt maximal 50% der Breite der angrenzenden Passagen auf. Durch das angestrebte große Verhältnis von Breite/Höhe der Passagen erfolgt der Wärmeübergang überwiegend direkt in die Wärmeübertragungsbereiche, während über die seitlichen Flächen der Stege nur eine geringe Übertragung von Wärme erfolgt. Folglich sind die Stege nicht als Kühlrippen konzipiert, die den überwiegenden Anteil der übertragenen Wärmemenge aufnimmt und dann über den Kühlrippenfuß, d.h. indirekt mit einem Umweg an die Wärmeübertragungsbereiche **13** (vgl. z.B. **Fig.4a**) weitergibt. Folglich spielen die Stege anders als bei Kühlrippen keine nennenswerte Rolle bei der Wärmübertragung und können somit auch aus einem schlecht wärmeleitenden Material bestehen.

Die vorgenannte, im Vergleich zum Querschnitt kleine Länge der Vielzahl von Passagen ist einer Parallelschaltung einer Vielzahl von Einlaufströmungen. Bei Einlaufströmungen bildet sich mit zunehmendem Strömungsweg ein stationärer Strömungszustand mit wärmeisolierender Grenzschicht aus, d.h. mit zunehmender Länge einer Passage nimmt die Wärmeübertragungseffizienz ab, aber auch der Strömungswiderstand zu. Durch eine kurze Länge erhält man folglich gleichermaßen bevorzugt eine hohen Wärmeübergang und eine geringen Strömungswiderstand. Die Verweilzeit der Wärmeübertragungsflüssigkeit sowie die Graetz-Zahl sind sehr klein, was zu einer Erhöhung der Nusselt-Zahl führt. Durch diese Parallelschaltung der Passagen und die kurze Passagenlänge ist der Druckverlust gering. Typische Abmessungen der Passagen sind z.B. 0,05 bis 0,2, vorzugsweise 0,1 bis 0,15 mm für die Höhe, 0,5 bis 1,5 mm, vorzugsweise 0,8 bis 1,0 mm für die Passagenbreite sowie 0,3 bis 1,0 mm, vorzugsweise 0,5 bis 0,6 mm für die Passagenlänge bzw. die Dicke der Wandungen **4.**

**Fig.3a** **und b** geben die Komponenten eines Mikrowärmeüberträgers mit Anordnungen gemäß des Beispiels zur Veranschaulichung wieder. Der Mikrowärmeüberträger umfasst die in **Fig.3a** dargestellte Trägerplatte **11** mit den vorgenannten Zu- und Ableitungskanalstrukturen **1** bzw. **2,** der trennenden Wandung **4** sowie den Verteilungsvolumina **5** und **6** als eingearbeitete Vertiefungen sowie dem Zu- und Ablauf **7** bzw. **8** als Durchbrüche. Außerdem ist auf der Trägerplatte um die vorgenannten Vertiefungen eine Umlaufrille **14** zur Aufnahme eines Klebstoffes und/oder Dichtmittel **15** zu einer aufliegenden Deckfolie **11** (vgl. **Fig.4a** **und b**) vorgesehen. Die Passagen **3** sind dagegen als orthogonal zu den Kanalstrukturen **1** und **2** ausgerichtete Rillen in der Deckfolie **12** eingearbeitet (z.B. mechanisch), wobei deren Erstreckungsbereich den vorgenannten Wärmeübertragungsbereich **13** bildet. Der korrespondierende Querschnitt orthogonal durch die Kanalstrukturen **1** und **2** und auf der Höhe der Passagen **3** ist in **Fig.4a** dargestellt.

Vorzugsweise sind die Trägerplatte **11** aus einem schlechten und die Deckfolie **12** aus einem guten Wärmeleitermaterial hergestellt. Diese Materialwahl hat den Vorteil, dass die Wärmeübertragung zielgerichtet in den Passagen erfolgt, während sie in den Kanalstrukturen möglichst unterbunden wird. Vorzugweise wird zwischen Trägerplatte und Deckfolie zusätzlich eine Wärmedämmfolie mit Durchbrüchen deckungsgleich mit den Passagen eingelegt, wobei diese ebenso zur Verschweißung der Trägerplatte zur Deckfolie heranziehbar ist. Grundsätzlich ist bei der vorgenannten Materialpaarung aber mit einem unterschiedlichen thermischen Ausdehnungsverhalten und einer damit verbundenen Neigung zu Scherspannungen oder Relativbewegungen zu rechnen, was eine dauerhafte Verschweißung erschwert oder die vorgenannte zusätzliche Umlaufrille **14** für eine Verklebung oder Aneinanderpressung erforderlich macht. Alternativ kann gegen ein seitliches Verrutschen auf der Deckfolie auch ein in die Umlaufrille **14** eingreifender formschlüssiger Grad vorgesehen sein, der in einer weiteren Ausführungsvariante auch als Presssitz für die Fügung von Trägerplatte und Deckfolie konzipierbar ist.

**Fig.4b** gibt einen Wärmeübertragungsbereich **13** mit beidseitiger Anordnung von zwei der vorgenannten Wärmeübertägers wieder. Sie eignet sich insbesondere als Gegenstrom-Wärmetauscher in Verbindung mit der vorgenannten ersten Ausführungsform (vgl. **Fig.2a** **und b**).

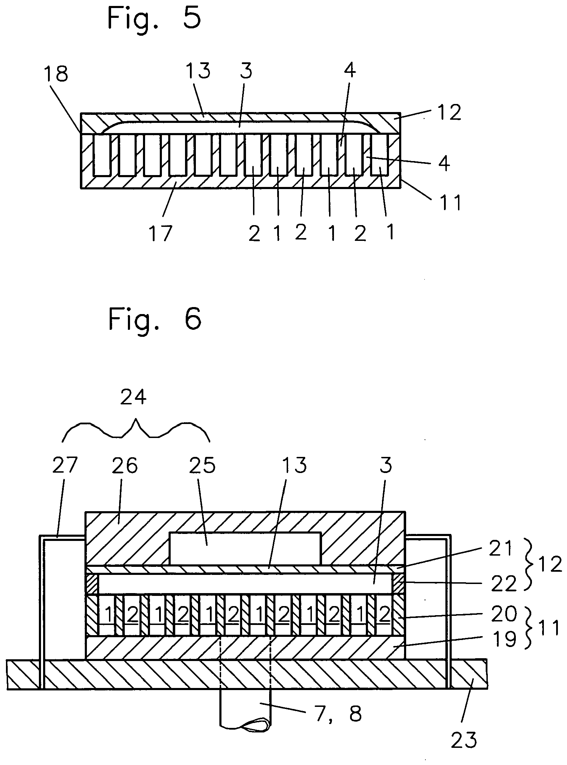

**Fig.5** zeigt dagegen einen Querschnitt entsprechend der **Fig.4a** einer weiteren Ausführungsform. Hierbei wird auf die vorgenannte Umlaufrille und dem Dichtmittel zugunsten einer kompakteren Bauausführung verzichtet. Trägerplatte **11** und Deckfolie **12** bestehen vorzugsweise aus gleichen oder miteinander thermisch verbindbare Materialien, vorzugsweise einem Metall, einer Metalllegierung oder einem Kunststoff und werden vorzugsweise mit einem Diffusionsschweißverfahren fluiddicht miteinander verbunden. Zur Vermeidung von größeren Scherspannungen an der Trennfuge **18** wurde im Rahmen diese Ausführungsbeispiels der unstrukturierte Bodenbereich **17** der Trägerplatte **11** möglichst dünn und damit elastisch nachgiebig gestaltet. Vorzugsweise übersteigt dabei die Höhe der Wandungen **4** und damit die Tiefe der Kanalstrukturen **1** und **2** die Stärke des Bodenbereichs, vorzugsweise um das doppelte. Die in **Fig.5** nicht weiter dargestellten Zu- und Abläufe müssen dabei nicht wie bei den in **Fig.3** **und** **4** dargestellten Ausführungsbeispielen den Bodenbereich durchdringen, sondern können beispielsweise auch stirnseitig durch die Trägerplatte **11** oder durch die Deckfolie **12** in den Mikrowärmeüberträger einmünden.

Eine Schnittdarstellung entsprechend **Fig.4a** **und b und 5** einer alternativen konstruktiven Gestaltung für den Einsatz als Fluidkühler für elektronische Bauteile auf einer Leiterplatte zeigt **Fig.6****.** Der dargestellte Mikrowärmeüberträger weist im Gegensatz zu allen vorgenannten Ausführungsbeispielen nur durchbrochen strukturierte oder unstrukturierte Platten oder Folien auf. Die Trägerplatte **11** wird durch eine bis auf die Durchbrüche für den Zu- und Ablauf **7** bzw. **8** unstrukturierte Bodenplatte **19** (entsprechend dem Bodenbereich) und einer aufgesetzten, im Bereich der Kanalstrukturen 1 und 2 sowie der Verteilungsvolumen **5** und **6** für den Zulauf **7** bzw. Ablauf **8** durchbrochenen Strukturplatte **20** zusammengesetzt. Ebenso setzt sich die Deckfolie **12** aus einer unstrukturierten Wärmeleitfolie **21** und einer im Bereich der Passagen durchbrochenen Strukturfolie **22** zusammen. Die Anordnung der Durchbrüche in der Strukturfolie und der Strukturplatte folgt den vorgenannten Gestaltungsgrundsätzen für die Fluidführungen (Kanalstrukturen mit Wandungen, Passagen, Verteilungsvolumina etc.) bei den vorgenannten Ausführungsbeispielen und sind beispielhaft in den **Fig.3a** **und b** wiedergegeben. Auch hier eignet sich z.B. ein Diffusionsschweißen als probates Fügeverfahren für den Schichtaufbau des Mikrowärmeüberträgers.

Für einen Einsatz als Fluidkühler für elektronische Bauteile ist der in **Fig.6** dargestellte Mikrowärmeüberträger auf eine Platine **23** aufgesetzt, wobei die Zu- und Ableitung **7** bzw. **8** durch die Platine hindurchragen. Es ist aber auch möglich, die Zu- und Ableitung durch dafür vorgesehene Kanale in einer Multilayer-Platine zu integrieren. Das elektronische Bauteil **24** selbst umfasst eine elektronische Schaltung **25** wie z.B. einen Prozessor, der die abzuführende Wärmemenge produziert und direkt auf die Wärmeleitfolie **21** aufgesetzt ist. Das elektronische Bauteil umfasst ferner ein Gehäuse **26** und elektrische Kontaktlitze **27** zum Anschluss der Schaltung an Leiterbahnen auf der Platine.

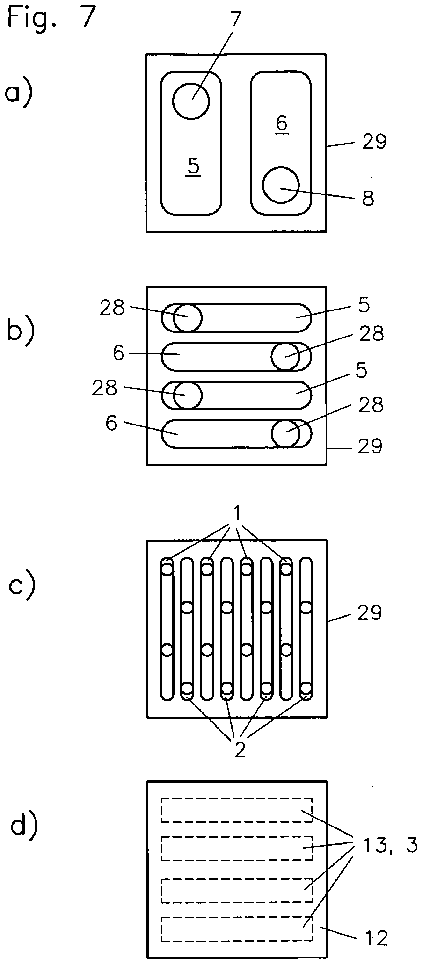

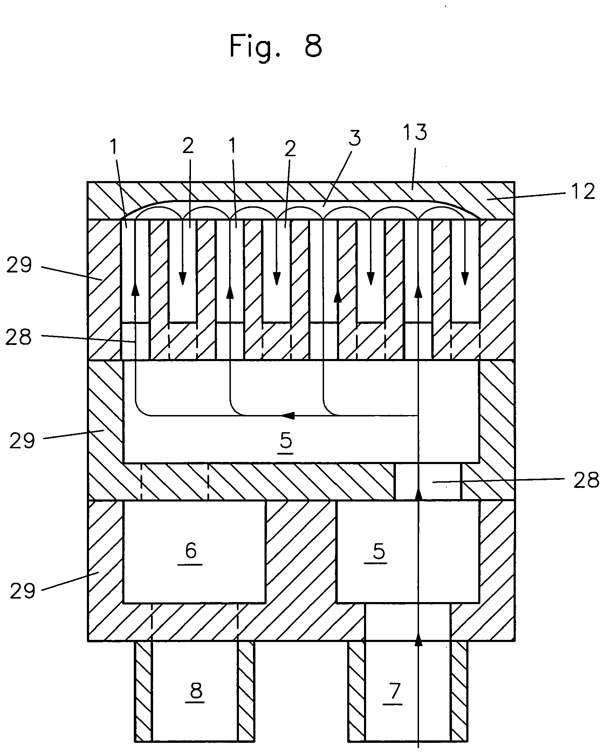

**Fig.7a** **bis d und 8** zeigen eine weitere Ausführungsform des Mikrowärmeüberträgers. Wesentlich ist dabei, dass sich die Kanalstrukturen 1 und 2 mit jeweils zugehörigen Verteilungsvolumina **5, 6** über mindesten zwei, im Ausführungsbeispiel drei Ebenen erstrecken. Wie bei den vorgenannten Ausführungsvarianten ist der Wärmeübertragungsbereich **13** und die Passagen **3** in der Deckfolie **12** integriert (vgl. Draufsicht **Fig.7d** und Schnittdarstellung **Fig.8** oben). Die Gestaltung und die Wirkung der Passagen sowie der für effektive Wärmeübertragung dünne Wärmeübertragungsbereich wurden ebenso nach den vorgenannten Kriterien konzipiert. Ebenso wie bei den vorgenannten Ausführungsbeispielen befindet sich unter der Deckfolie eine Folie **29** mit den Kanalstrukturen 1 und 2, umfassend eine Vielzahl von parallel zueinander angeordneten Kanälen (vgl. **Fig.7c**). Die Kanalstrukturen sind als Kanäle in abwechselnder Reihenfolge ineinander verschlungen. Die Passagen **3** in der Deckfolie **12** und die Kanalstrukturen 1 und 2 in der Folie **29** liegen bevorzugt orthogonal zueinander ausgerichtet mit ihren jeweiligen offenen Kanalstrukturen aufeinander (vgl. **Fig.7c** **und d und 8**).

Im Gegensatz zu den vorgenannten Ausführungen sind die Verteilungsvolumina **5** und **6** für den Zulauf **7** bzw. den Ablauf **8** nicht in einer Ebene seitlich der Kanalstrukturen **1** und **2** angeordnet, sondern in mindestens einer separaten Ebene unterhalb der Ebene mit den Kanalstrukturen **1** und **2.** Sie bestehen wie die Kanalstrukturen bevorzugt aus in je eine Folie **29** je Ebene eingearbeiteten Kanälen. Die Kanäle pro Ebene, d.h. auch pro Folie sind - wie in **Fig.7a** **bis c und 8** wiedergegeben - bevorzugt parallel zueinander und vorzugsweise in abwechselnder Reihenfolge bezüglich ihrer Zugehörigkeit zum Zulauf bzw. Ablauf angeordnet. Alle Kanalstrukturen in den Folien weisen Verbindungsöffnungen **28,** d.h. Durchbrüche durch die Folien **29** im Bodenbereich der Kanäle auf, die die jeweiligen Verteilungsvolumina selektiv nur mit den jeweiligen darunter liegenden Verteilungsvolumina mit der jeweils gleichen Zugehörigkeit zum Zulauf **7** bzw. Ablauf **8** verbinden. Ein Wärmeübertragungsmedium, z.B. Wasser oder Öl durchströmt folglich nach Passieren des Zulaufs zwingend alle Ebenen und tritt nach Durchtritt der Passagen **3** in die Kanalfraktionen mit Zugehörigkeit zum Ablauf ein. In diesen erfolgt eine Weiterleitung wieder durch alle Ebenen in umgekehrter Reihenfolge zum Ablauf **8** (vgl. **Fig.8**). Der Strömungsverlauf vom Zulauf über die Verteilungsvolumina (Zulauf) **5** (mit Durchtritt durch die Verbindungsöffnungen **28**), Kanalstrukturen **1,** Passagen **3** bis hin zu den Kanalstrukturen **2** ist in **Fig.8** beispielhaft mit einem sich verzweigenden Pfeil wiedergegeben.

Ein Merkmal dieser Ausführungsform betrifft das Layout der Kanäle in den Ebenen. Die Kanäle kreuzen sich bevorzugt senkrecht (vgl. **Fig.7a** **bis c**) mit den Kanälen der jeweils benachbarten Ebene, die Folien bzw. Ebenen mit jeder Ebene in Richtung des Wärmeübertragungsbereichs (**13**) eine zunehmende Anzahl von vorzugsweise immer feiner werdenden Kanälen umfassen. In jeder Ebene sind die Kanäle in abwechselnder Reihenfolge vorzugsweise parallel zueinander angeordnet (vgl. **Fig.7a** **bis c**) und jeweils über die Verbindungsöffnungen **28** zu den jeweiligen Kanälen der Kanalstrukturen verbunden. Die erste der Folien **29** sowie die auf diese aufgebrachte Deckfolie **12** umfassen die eigentlichen Wärmeübertragungsstruktur, während die restlichen, darunter liegenden Folien **29** die Verteilungsvolumina umfassen. Die Folien sind vorzugsweise aus einem für das Kühlungsmedium wie Wasser korrosionsbeständigem Metall (z.B. VA-Stahl, Messing etc.) gefertigt und werden über ein Diffusionsschweißverfahren miteinander verbunden.

Der besondere Vorteil dieser weiteren Ausführungsform liegt in der guten Skalierbarkeit der Bauform. Der Zu und Ablauf des Mikrowärmetauschers wird mit jeder Ebene verzweigt, d.h. durch ein Hinzufügen oder Weglassen lassen sich praktisch beliebige Verzweigungen mit feinen Verzweigungsabstufungen realisieren. Durch die sehr kurzen Wärmeübertragungswege vom Kühlmedium in den Passagen durch den Wärmeübertragungsbereich **13** an die zu kühlende Komponente ohne einen Umweg über weitere Komponenten wie z.B. Kühlrippen besteht ein besonderer Vorteil aller Varianten des Mikrowärmeüberträgers gemäß dieser Erfindung darin, dass das Material im Wärmübertragungsbereich nicht zwingend eine sehr gute Wärmeleitfähigkeit aufweisen muss und daher zugunsten einer höheren Korrosionsbeständigkeit und damit der Lebensdauer wählbar ist. Grundsätzlich erstreckt sich dadurch das Materialspektrum für den Mikrowärmetauscher nicht nur auf korrosionsbeständige Metalle, sondern auch andere Werkstoffe wie Gläser, Kunststoffe oder Keramiken.

### Bezugzeichenliste

- 1: Zuleitungskanalstruktur
- 2: Ableitungskanalstruktur
- 3: Passage
- 4: trennenden Wandung
- 5: Verteilungsvolumen Zulauf
- 6: Verteilungsvolumen Ablauf
- 7: Zulauf
- 8: Ablauf
- 9: Durchströmungsrichtung
- 10: Barriere
- 11: Trägerplatte
- 12: Deckfolie
- 13: Wärmeübertragungsbereich
- 14: Umlaufrille
- 15: Dichtmittel
- 16: Teilabschnitt
- 17: Bodenbereich
- 18: Trennfuge
- 19: Bodenplatte
- 20: Strukturplatte
- 21: Wärmeleitfolie
- 22: Strukturfolie
- 23: Platine
- 24: Elektronisches Bauteil
- 25: Elektronische Schaltung
- 26: Gehäuse
- 27: Kontaktilitze
- 28: Verbindungsöffnung
- 29: Folie

## Patentansprüche

1. Mikrowärmeüberträger zur Übertragung von hohen flächenspezifischen Wärmemengen, umfassend
a) einen Wärmeübertragungsbereich (**13**),
b) je einer Kanalstruktur (**1**) und je einer weiteren Kanalstruktur (**2**) mit jeweils zugehörigen Verteilungsvolumina (**5, 6**) und Zu- und Ablauf (**7, 8**) jeweils für mindestens ein Wärmeüberträgermedium im Mikrowärmeüberträger sowie
c) eine Anzahl von Passagen (**3**) als einzige Verbindung für je ein Wärmeüberträgermedium jeweils zwischen der Kanalstruktur **(1)** und der weiteren Kanalstruktur **(2),**
wobei
d) die Kanalstruktur **(1)** und die weitere Kanalstruktur **(2)** je Wärmeübertragungsmedium in abwechselnder Reihenfolge ineinander verschlungen angeordnet sind,
e) die Passagen nahe dem Wärmeübertragungsbereich angeordnet sind und
f) Kanalstruktur, weitere Kanalstruktur sowie die Passagen sich über den gesamten Wärmeübertragungsbereich erstrecken,
g) die Kanalstruktur **(1)** und die weitere Kanalstruktur **(2)** durch Barrieren (**10**) in Teilabschnitte (**16**) unterteilt sind, wobei jeder Teilabschnitt mit mindestens zwei benachbarten Teilabschnitten über jeweils mindestens einer Passage (**3**) verbunden ist,
**dadurch gekennzeichnet, dass**
h) zwischen den Kanalstrukturen **(1, 2)** trennende Wandungen (4) in Flussrichtung angeordnet sind, die von den Passagen **(3)** überbrückt werden.

2. Mikrowärmeüberträger nach Anspruch 1, umfassend nur eine Kanalstruktur (1) und eine weitere Kanalstruktur (**2**) für nur ein Wärmeübertragungsmedium, wobei der Wärmeübertragungsbereich (**13**) durch eine Wärmeübertragungsaußenfläche gebildet wird.

3. Mikrowärmeüberträger nach einem der vorgenannten Ansprüche, wobei die Kanalstrukturen (**1, 2**) mit je einem Verteilungsvolumen (**5, 6**) je Wärmeübertragungsmedium jeweils eine ebene verschlungene Kanalstruktur bilden, wobei die verschlungenen Kanalstrukturen gegeneinander auf einer gemeinsamen Ebene angeordnet sind und die Kanäle der Kanalstrukturen (**1, 2**) in abwechselnder Reihenfolge parallel zueinander angeordnet sind.

4. Mikrowärmeüberträger nach einem der Ansprüche 1 bis 3, wobei die Verteilungsvolumina (**5, 6**) durch Kanalgruppen mit eindeutiger Zugehörigkeit zum Zulauf (**7**) bzw. Ablauf (**8**) in mehreren Ebenen angeordnet sind.

5. Mikrowärmeüberträger nach Anspruch 4, wobei die Kanalgruppen in jeder Ebene in Richtung des Wärmeübertragungsbereichs (**13**) eine zunehmende Anzahl von Kanälen umfassen, die je Ebene in abwechselnder Reihenfolge parallel zueinander angeordnet sind und jeweils Verbindungsöffnungen (**28**) zu den jeweiligen Kanalgruppen mit gleicher Zugehörigkeit zum Zulauf bzw. Ablauf in den benachbarten Ebenen verbunden sind.

6. Mikrowärmeüberträger nach Anspruch 4 oder 5, wobei die Ebenen jeweils durch Platten oder Folien (**29**) mit einseitig eingearbeiteten Kanalgruppen und Durchbrüchen als Verbindungsöffnungen (**28**) in den Kanälen gebildet werden.

7. Mikrowärmeüberträger nach einem der vorgenannten Ansprüche, wobei die die Zu- und Ableitungskanalstruktur je Wärmeübertragungsmedium als rillenförmige Vertiefungen einseitig in eine Trägerplatte (**11**) eingearbeitet sind und durch eine Deckfolie (**12**) dichtend abgedeckt ist, wobei die Passagen (**3**) als Rillenstrukturen in die Deckfolie eingearbeitet auf den rillenförmigen Vertiefungen angeordnet sind sowie die Deckfolie den Wärmeübertragungsbereich umfasst.

8. Mikrowärmeüberträger nach Anspruch 7, wobei die Rillenstrukturen orthogonal zu den rillenförmigen Vertiefungen angeordnet sind.

9. Verwendung eines Mikrowärmeüberträgers nach einem der vorgenannten Ansprüche für einen Fluidkühler für ein mit dem Wärmeübertragungsbereich (**13**) verbundenes elektronisches Bauteil.

## Claims

1. Micro-heat exchanger for the exchange of surface-specific heat quantities, comprising
a) a heat exchanging region (13),
b) in each case a channel structure (1) and a further channel structure (2) with respectively associated distribution volumes (5, 6) and inlet and outlet (7, 8) in each case for at least one heat exchanging medium in the micro-heat exchanger, and
c) a number of passages (3) as the only connection for a heat exchanging medium between the channel structure (1) and the further channel structure (2),
wherein
d) the channel structure (1) and the further channel structure (2) are arranged per heat exchanging medium in an alternating sequence such as to be intertwined,
e) the passages are arranged close to the heat exchanging region, and
f) the channel structure, further channel structure, and the passages extend over the entire heat exchanging region,
g) the channel structure (1) and the further channel structure (2) are subdivided by barriers (10) into part sections (16), wherein each part section is connected to at least two adjacent part sections in each by at least one passage (3),
**characterised in that**
h) partitioning walls (4) between the channel structures (1, 2) are arranged in the flow direction, which are bridged by the passages (3).

2. Micro-heat exchanger according to claim 1, comprising only one channel structure (1) and one further structure (2) for only one heat exchanging medium, wherein the heat exchanging region (13) is formed by a heat exchanging outer surface.

3. Micro-heat exchanger according to any one of the preceding claims, wherein the channel structures (1, 2), in each case with a distribution volume (5, 6) for each heat exchanging medium, in each case form a flat intertwined channel structure, wherein the intertwined channel structures are arranged against one another on a common plane and the channels of the channel structures (1, 2) are arranged in an alternating sequence parallel to one another.

4. Micro-heat exchanger according to any one of claims 1 to 3, wherein the distribution volumes (5, 6) are arranged through channel groups with unambiguous allocation to the inlet (7) and outlet (8) respectively in a plurality of planes.

5. Micro-heat exchanger according to claim 4, wherein the channel groups in each plane comprise an increasing number of channels in the direction of the heat exchanging region (13), which are arranged per plane parallel to one another in an alternating sequence, and in each case connection openings (28) to the respective channel groups with the same allocation are connected to the inlet and outlet respectively in the adjacent planes.

6. Micro-heat exchanger according to claim 4 or 5, wherein the planes are in each case formed by plates or films (29) with channel groups worked into one side and passage apertures are formed in the channels as connection openings (28).

7. Micro-heat exchanger according to any one of the preceding claims, wherein the inlet and outlet channel structure per heat exchanging medium are worked into a carrier plate (11) on one side, as groove-like depressions, and are covered with sealing effect by a cover film (12), wherein the passages (3), worked into the cover film as groove structures, are arranged on the groove-like depressions, and the cover film comprises the heat exchanging region.

8. Micro-heat exchanger according to claim 7, wherein the groove structures are arranged orthogonally to the groove-like depressions.

9. Use of a micro-heat exchanger according to any one of the preceding claims for a fluid cooler for an electronic component connected to the heat exchanging region (13).

## Revendications

1. Micro-échangeur de chaleur permettant l'échange de quantités de chaleur spécifiques à des surfaces importantes comprenant :
a) une zone d'échange de chaleur (13),
b) une structure de canaux respective (1) et une autre structure de canaux respective (2) auxquelles sont respectivement associés des volumes de distribution (5, 6) et une entrée et une sortie (7, 8) respective pour au moins un fluide d'échange de chaleur dans le micro-échangeur de chaleur, et
c) un ensemble de passages (3) constituant les seules liaisons pour chaque fluide échangeur de chaleur respectivement entre la structure de canaux (1) et l'autre structure de canaux (2),
dans lequel,
d) la structure de canaux (1) et l'autre structure de canaux (2) sont entrelacées l'une dans l'autre pour chaque fluide d'échange de chaleur selon une succession alternée,
e) les passages sont situés à proximité de la zone d'échange de chaleur, et
f) la structure de canaux, l'autre structure de canaux ainsi que les passages s'étendent sur la totalité de la zone d'échange de chaleur,
g) la structure de canaux (1) et l'autre structure de canaux (2) étant subdivisées par des barrières (10) en des segments partiels (16), chaque segment partiel étant relié à au moins deux segments partiels voisins par respectivement au moins un passage (3),
**caractérisé en ce que**
h) entre les structures de canaux (1, 2) sont montés dans le sens de circulation des parois de séparation qui sont enjambées par les passages (3).

2. Micro-échangeur de chaleur conforme à la revendication 1,
ne comprenant qu'une structure de canaux (1) et une autre structure de canaux (2) pour uniquement un seul fluide d'échange de chaleur, la zone d'échange de chaleur (13) étant formée par une surface externe d'échange de chaleur.

3. Micro-échangeur de chaleur conforme à l'une des revendications précédentes,
dans lequel les structures de canaux (1, 2) forment, respectivement avec un volume de distribution (5, 6) respectif pour un fluide d'échange de chaleur respectif une structure de canal entrelacée plane, les structures de canaux entrelacées étant montées en regard dans un plan commun et les canaux des structures (1, 2) étant parallèles selon une succession alternée.

4. Micro-échangeur de chaleur conforme à l'unes des revendications 1 à 3,
dans lequel les volumes de distribution (5, 6) sont situés dans plusieurs plans au travers de groupes de canaux avec une attribution claire à l'entrée (7) ou à la sortie (8).

5. Micro-échangeur de chaleur conforme à la revendication 4,
selon lequel
les groupes de canaux comportent dans chaque plan, en direction de la zone d'échange de chaleur (13) un nombre croissant de canaux, qui sont pour chaque plan disposés parallèlement les uns aux autres selon une succession alternée, et, des ouvertures de liaisons respectives (28) vers les différents groupes de canaux ayant la même attribution à l'entrée ou à la sortie sont reliées dans des plans voisins.

6. Micro-échangeur de chaleur conforme à la revendication 4 ou 5,
dans lequel
les plans sont respectivement formés par des plaques ou des feuilles (29), avec des groupes de canaux incorporés d'un côté et des évidements en tant qu'ouvertures de liaison (28) dans les canaux.

7. Micro-échangeur de chaleur conforme à l'une revendications précédentes,
dans lequel
les structures de canaux d'alimentation et d'évacuation de chaque fluide d'échange de chaleur sont incorporées sous la forme de renfoncements en forme de rainures, sur un côté dans une plaque support (11), et sont recouverts de façon étanche par une feuille de couverture (12), les passages (3) incorporés sous la forme de structures de rainures dans la feuille de couverture, étant disposé dans les renfoncements en forme de rainures, et la feuille de couverture comprenant la zone d'échange de chaleur.

8. Micro-échangeur de chaleur conforme à la revendication 7,
selon lequel
les structures en forme de rainures sont perpendiculaires aux renfoncements en forme de rainures.

9. Utilisation d'un micro-échangeur de chaleur conforme à l'une des revendications précédentes,
pour un refroidisseur de fluide destiné à un composant électronique lié à la zone d'échange de chaleur (13).
